Europäisches Patentamt

European Patent Office

Office européen des brevets

(11) Veröffentlichungsnummer: **0 075 332**
**A2**

## (12) EUROPÄISCHE PATENTANMELDUNG

(21) Anmeldenummer: **82108788.9**

(22) Anmeldetag: **22.09.82**

(51) Int. Cl.³: **H 03 J 7/06**

(30) Priorität: **23.09.81 DE 3137891**

(43) Veröffentlichungstag der Anmeldung: **30.03.83**
**Patentblatt 83/13**

(84) Benannte Vertragsstaaten: **AT DE FR GB IT**

(71) Anmelder: **SIEMENS AKTIENGESELLSCHAFT, Berlin und München Wittelsbacherplatz 2, D-8000 München 2 (DE)**

(72) Erfinder: **Stepp, Richard, Dipl.-Ing., Elisabethstrasse 25, D-8000 München 40 (DE)**

(54) **Empfängerschaltung.**

(57) Die Erfindung bezieht sich auf eine Schaltung für einen Empfänger für den Fernseh- oder Rundfunkempfang mit Synthesizer-Abstimmung, wobei eine durch das informationsbehaftete Eingangssignal sowie durch einen mittels eines nach dem Frequenzsyntheseverfahren arbeitenden Regelkreis geregelten Oszillator beaufschlagte Mischstufe vorgesehen ist. Am Ausgang dieser Mischstufe erscheint ein mit der empfangenen Information versehenes Zwischenfrequenzsignal. Solche an sich bekannte Empfängerschaltungen lassen sich gemäss der Erfindung im Interesse der Störungsfreiheit des vom Empfänger gelieferten Ausgangssignals merklich gegenüber den bekannten Schaltungen dieser Art verbessern und dennoch weitgehend monolithisch integrieren. Hierzu ist gemäss der Erfindung vorgesehen, dass alternativ zu der vom Oszillator VCO gelieferten Frequenz oder einer von dieser Frequenz durch Teilung abgeleiteten Frequenz $f_o$ die vom Ausgang der Mischstufe Mi gelieferte Zwischenfrequenz $f_{zf}$ oder einer von dieser durch Teilung erhaltene Frequenz als Istwert an den nach dem Frequenzsyntheseverfahren arbeitenden Regelkreis unter Beibehaltung des Oszillators VCO als Stellglied anschaltbar ist.

Siemens Aktiengesellschaft
Berlin und München

Unser Zeichen 0075332
VPA

81 P 1 1 4 5 E

Empfängerschaltung

Die Erfindung betrifft eine Empfängerschaltung mit einer durch das informationsbehaftete Eingangssignal sowie durch einen mittels eines nach dem Frequenzsyntheseverfahren arbeitenden Regelkreis geregelten Oszillator beaufschlagten Mischstufe, an deren Ausgang ein mit der empfangenen Information versehenes und an einen der weiteren Auswertung dienenden Schaltungsteil weiterzugebendes Zwischenfrequenzsignal erscheint.

Eine solche Empfängerschaltung ist z.B. durch die Literaturstelle "Funkschau" (1979), Heft 1, S. 5 - 9, bekannt.

Bekanntlich wird bei einer nach dem sog. Frequenzsyntheseverfahren erfolgenden Abstimmung eines Fernsehemfängers die sog. PLL-Synchronisation verwendet, die auch unter der Bezeichnung "Nachlauf-Synchronisation" bekannt ist. Die Aufgabe einer solchen Synchronisierung besteht darin, die Frequenz $f_2$ eines einstellbaren Nachlauf-Oszillators so einzustellen, daß sie mit der Frequenz $f_1$ eines als Sollwertgeber dienenden Oszillators so genau übereinstimmt, daß die Phasenverschiebung nicht wegläuft. Die hierzu angewendete Schaltung besteht prinzipiell aus dem durch eine elektrische Spannung einstellbaren Nachlaufoszillator, der den Istwert seiner Frequenz $f_2$ an den einen Eingang eines Phasendetektors liefert. Der andere Eingang des Phasendetektors wird durch einen den Sollwert liefernden Referenzoszillator beaufschlagt. Der Ausgang des Phasendetektors steuert den Eingang eines Reglers, der eine der Stellgröße entsprechende Steuerspannung an den Nachlaufoszillator abgibt.

Der Nachlaufoszillator ist z.B. als Tuneroszillator ausgebildet. Die vom Tiefpaßausgang des Reglers abgegebene und dem Stellwert entsprechende Gleichspannung dient zur Einstellung der z.B. durch eine Kapazitätsdiode gegebenen frequenzbestimmenden Kapazität des z.B. durch einen LC-Oszillator gegebenen Nachlaufoszillators, der gewöhnlich mit "VCO" bezeichnet wird. Bei den in der genannten Literaturstelle "Funkschau" (1979)1, S. 5 - 9, beschriebenen Schaltung für einen Fernseher wird nun von dem soeben beschriebenen Verfahren Gebrauch gemacht, indem der Tuneroszillator in der beschriebenen Weise frequenzgeregelt ist. Als Sollwertgeber dient dabei ein quarzgesteuerter Referenzsoszillator, der unter Vermittlung wenigstens eines aus mehreren Stufen bestehenden Frequenzteilers auf den Phasendetektor der PLL-Regelkreisschaltung arbeitet. Dabei ist es möglich, den Sollwerteingang des Phasendetektors alternativ auf den Teilerausgang verschiedener Stufen des Frequenzteilers zu schalten, was z.B. unter Vermittlung eines Prozessors geschehen kann. Auf diese Weise kann eine Kanaleinstellung des als Nachlaufoszillator geschalteten Tuners erreicht werden.

Nun ist es in Überlagerungsempfängern für den Fernseh- oder auch für den Rundfunkbereich notwendig, für die jeweils eingestellte Eingangsfrequenz $f_i$ die Tuneroszillator-frequenz $f_o$ sowohl temperaturstabil als auch reproduzierbar genau auf den Wert $f_o = f_i + f_{ZF}$ einzustellen, wobei $f_{ZF}$ die Trägerfrequenz der am Ausgang der Mischstufe abgegebenen Zwischenfrequenzsignale bedeutet. Das wird durch die beschriebene Regelung nach dem PLL-Verfahren erreicht. Zum anderen ist es aber auch erwünscht, eine temperaturstabile, reproduzierbare und genaue ZF-Frequenz zur Verfügung zu haben, was sowohl für eine kohärente (synchrone) als auch für eine inkohärente (d.h. quasisynchrone oder Hüllkurven-) Demodulation gilt. Wünschenswert ist außerdem, wenn die ZF-Frequenz $f_{ZF}$ software-programmierbar veränderbar ist.

- 3 -  VPA 81 P 1145 E

0075332

An sich besteht die Möglichkeit, Temperaturprobleme, und Restfrequenzverstimmungsprobleme mittels bekannter AFC-Schaltungen (AFC = Automatic Frequency Control) allein bzw. in Kombination mit einem Frequenzsynthesesystem zu behandeln. Der hierzu erforderliche schaltungsmäßige Aufwand ist jedoch beträchtlich. Wünschenswert ist daher eine Lösung, die sich möglichst weitgehend monolithisch darstellen läßt, die also mit anderen Worten mit einem Minimum an externen Schaltungsmitteln zum Ziele kommt.

Für eine diesbezüglich günstige Lösung wird gemäß der Erfindung die eingangs definierte Empfängerschaltung derart ausgestaltet, daß alternativ zu der vom Oszillator gelieferten Frequenz oder einer von dieser Frequenz durch Frequenzteilung abgeleiteten Frequenz die vom Ausgang der Mischstufe gelieferte Zwischenfrequenz oder eine von dieser durch Frequenzteilung erhaltene Frequenz als Istwert an den nach dem Frequenzsyntheseverfahren arbeitenden Regelkreis anschaltbar ist.

Dadurch wird es möglich, software-gesteuert entweder im normalen Frequenzsynthese-PLL-Betrieb oder im ZF-PLL-Betrieb das Verhalten des Empfängers zu regeln. Die Stabilität der Oszillatorfrequenz bzw. der ZF-Frequenz wird nur noch von der Quarzstabilität des Referenzoszillators im Regelkreis bestimmt. Dadurch werden Frequenzfehler, wie sie bei Schaltungen mit AFC-Anlagen unvermeidlich sind, ausgeschaltet, und zwar deswegen, weil die Anlage nunmehr als APC-Anlage (APC = Automatic Phase Control) arbeitet. Die Anwendung des erfindungsgemäßen Vorschlags erlaubt, daß man die Zwischenfrequenz $f_{ZF}$ jederzeit programmierbar verändern kann. Je nach Empfangssituation bzw. dem Zustand des Empfängers kann der für den Einzelfall geeignetere Betrieb ausgewählt werden, indem man mittels eines Schalters von der einen Betriebsart auf die andere schaltet bzw. wieder zurückschaltet.

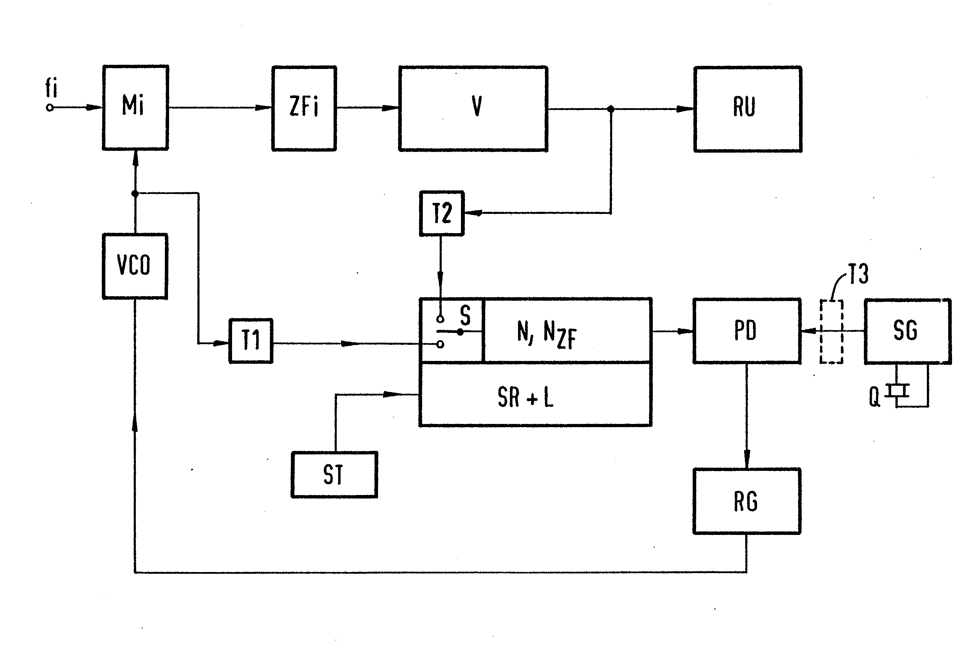

Die Erfindung wird nun anhand der Figur näher beschrieben. Vorausgesetzt wird dabei die Kenntnis einer nach dem Frequenzsyntheseverfahren arbeitenden Regelanlage. Diesbezügliche Einzelheiten findet man z.B. in dem Buch von Tietze-Schenk "Halbleiter-Schaltungstechnik" (1980), S. 701 - 703. Es empfiehlt sich, für die Frequenzsynthese eine integrierte Nachlauf-Synchronisationsschaltung entsprechend der DE-Patentanmeldung P 31 20 930.0 (VPA 81 P 1071) zu verwenden, da sich deren vorteilhafte Eigenschaften im vorliegenden Falle besonders bewähren können.

Wie aus dem Blockschaltbild gemäß der Zeichnung ersichtlich, gelangt das amplitudenmodulierte Eingangssignal $f_i$, insbesondere ein Fernsehsignal, an den Signaleingang einer in üblicher Weise aufgebauten Mischstufe Mi. Ein zweiter Eingang der Mischstufe Mi wird vom Ausgang des spannungsgesteuerten Oszillators VCO beaufschlagt. Im Mischer Mi entsteht dann in bekannter Weise durch Überlagerung des zu verarbeitenden Eingangssignals $f_i$ mit dem vom Oszillator VCO gelieferten Signal $f_o$ nicht nur ein Summensignal sondern auch das Differenzsignal $f_{ZF} = f_i - f_o$, das am Ausgang der Mischstufe Mi mittels eines Zwischenfrequenzfilters ZFi abgenommen und an einen Zwischenfrequenzverstärker V weitergegeben wird. Vom Zwischenfrequenzverstärker V gelangt das verstärkte Zwischenfrequenzsignal $f_{ZF}$ an einen der Demodulation sowie der Auswertung der im Eingangssignal $f_i$ vorhandenen Information dienenden und in üblicher Weise aufgebauten Schaltungsteil AU.

Der spannungsgesteuerte Oszillator VCO ist das Stellglied und die von ihm an die Mischstufe Mi entweder unmittelbar oder über einen Vorteiler T1 gelieferte Frequenz $f_o$ der Istwert bei dem einen Betriebszustand der erfindungsgemäßen Schaltung für einen Empfänger. Im anderen Betriebszustand wird das Stellglied und der übrige Regelkreis mit Ausnahme des Istwertgebers beibehalten.

Als Istwertgeber funktioniert im zweiten Betriebszustand der erfindungsgemäßen Anlage irgend ein Schaltungsteil, der das von der Mischstufe Mi gelieferte Zwischenfrequenzsignal $f_{ZF}$ oder ein durch Frequenzteilung aus diesem erhaltenes Signal führt. Beispielsweise ist dies der Zwischenfrequenzverstärker V, dessen Ausgang dann nicht nur an den der Auswertung des Zwischenfrequenzsignals $f_{ZF}$ dienenden Schaltungsteil sondern auch - entweder direkt oder unter Vermittlung eines Vorteilers T2 - an den nach dem Frequenzsyntheseverfahren arbeitenden Regelkreis anlegbar ist. Ebenso kann die vom Oszillator gelieferte Frequenz über den Vorteiler T1 oder auch direkt dem Eingang des nach dem Frequenzsyntheseverfahren arbeitenden Regelkreises zugeführt sein.

Der Eingang des Regelkreises ist durch einen in bekannter Weise ausgestalteten Phasendetektor PD (vgl. z.B. Tietze-Schenk "Halbleiter-Schaltungstechnik" (1980), S. 712) gegeben. Beispielsweise handelt es sich dabei um einen flankengetriggerten Phasendetektor. Er weist zwei Signaleingänge auf, von denen der eine durch den jeweiligen Istwert und der andere vom Sollwertgeber SG beaufschlagt ist. Der Sollwertgeber SG ist ein durch einen Schwingquarz Q gesteuerter Oszillator, dessen Ausgang unmittelbar oder über einen Frequenzteiler T3 auf den Phasendetektor PD geschaltet ist.

Der Ausgang des Phasendetektors PD ist über einen Regler RG an den durch eine Gleichspannung zu steuernden Stelleingang des Nachlaufoszillators VCO geschaltet. Dieser stellt in allen Fällen das Stellglied des Regelkreises dar, unabhängig davon, ob der steuernde Istwert durch die Oszillatorfrequenz $f_o$ oder durch die Zwischenfrequenz $f_{ZF}$ bestimmt ist. Ein Schalter S stellt nun wahlweise die Verbindung des Istwerteingangs des Phasendetektors PD mit je einer der beiden den Istwert für die Frequenzsynthese-Regelung liefernden Stellen, nämlich entweder mit dem Ausgang des Oszillators VCO bzw. des Teilers T1 oder dem Ausgang von ZFi bzw. des ZF-Verstärkers V (wie im gezeichneten Ausführungsbeispiel) her.

Zum Beispiel kann der Schalter S aus zwei einander gleichen Transistoren bestehen, an deren Stromeingangselektrode (also Emitterelektrode im Falle der Ausgestaltung mit Bipolartransistoren) beim einen Transistor das vom Nachlaufoszillator VCO bzw. vom Teiler T1 stammende Signal $f_o$ und beim anderen Transistor das Zwischenfrequenzsignal $f_{ZF}$ gelegt ist. Die Stromausgangselektroden (also im Beispielsfall die Kollektoren der beiden Transistoren) liegen gemeinsam - entweder unmittelbar oder über einen steuerbaren gemeinsamen Teiler N, $N_{ZF}$ am Eingang des Phasendetektors PD, der durch den Istwert des Regelvorgangs zu beaufschlagen ist. Die Steuerelektroden der beiden Transistoren werden alternativ von einem getriggerten Flip-Flop, z.B. einem JK-Flip-Flop, so gesteuert, daß stets nur ein Transistor eingeschaltet und damit für das an seinem Emitter ankommende Signal durchlässig ist, während der andere Transistor gesperrt ist. Mit dem nächsten Triggerimpuls wird der erstgenannte Transistor gesperrt, während der vorher gesperrt gewesene Transistor für das an seinem Emitter anhängige Signal nunmehr durchlässig wird. Die Schaltimpulse können z.B. von der Auswertestelle AU aufgrund von bei der Kontrolle des empfangenen Signals festgestellten Indizes oder manuell von der das empfangene Signal überwachenden Person ausgelöst werden. Im einfachsten Fall kann die Schaltanlage S durch einen manuell zu betätigenden mechanischen Wechselschalter realisiert sein, der den Istwerteingang des Phasendetektors PD bzw. des noch zu beschreibenden Schaltungsteils N, $N_{ZZ}$ (der die Vorstufe zum Phasendetektor PD auf der Istwertseite in den gezeichneten Beispielsfall darstellt) alternativ mit den die beiden Istwertsignale liefernden Quellen verbindet.

Bei komplizierteren Empfangsschaltungen, wie z.B. bei den in "Funkschau" (1979), H. 1, S. 5 - 9, beschriebenen Schaltungen, ist eine durch einen Mikroprozessor gesteuerte Kanalwahl und ggf. auch eine mikroprozessorgesteuerte Feineinstellung vorgesehen. Beides ist auch im Falle einer Empfängerschaltung gemäß der Erfindung möglich.

Beispielsweise kann man hierzu den als Verbindung zwischen dem Schalter S und dem Istwerteingang des Phasendetektors PD im gezeichneten Ausführungsbeispiel vorgesehenen Schaltungsteil N, $N_{ZF}$ so ausgestalten, daß er einen Frequenzteiler mit einstellbarem Teilerverhältnis aufweist, dessen Eingang über den Schalter S mit der jeweiligen Istwertquelle und dessen Ausgang mit dem Istwerteingang des Phasendetektors PD verbunden ist. Die jeweilige Einstellung des Teilers erfolgt beispielsweise unter Vermittlung eines mit einem Halteglied (Latch) ausgerüsteten Schieberegisters SR, das seine Steuerinformation von einer Steuereinheit, z.B. einem Mikroprozessor ST, erhält, und das die Einstellung des das Istwertsignal an den Phasendetektor PD liefernden Teilers in N, $N_{ZF}$ festlegt. In gleicher Weise kann dieses Schieberegister SR ggf. dazu verwendet werden, um die Einstellung eines zwischen dem Sollwertgeberoszillator SG und dem ihm zugeordneten Eingang des Phasendetektors PD liegenden, einstellbaren Teilers T3 in Übereinstimmung mit der Einstellung des erstgenannten Teilers in N, $N_{FZ}$ vorzunehmen. Das erwähnte Halteglied, das ebenfalls in bekannter Weise ausgestaltet ist, ist in der Zeichnung in Kombination mit dem Schieberegister SR dargestellt und mit dem Zeichen L angedeutet.

Die Ausgestaltung des durch den Phasendetektor PD aufgrund der in diesem festgestellten Regelabweichung gesteuerten Reglers RG kann in üblicher Weise erfolgen. Empfehlenswert ist jedoch, entsprechend der bereits ge-

0075332

nannten Patentanmeldung P 31 20 930.0 den Regler auszugestalten.

Diese Patentanmeldung betrifft eine integrierbare Nachlauf-Synchronisationsschaltung, bei der die von einem einstellbaren Oszillator gelieferten elektrischen Schwingungen an den einen Eingang eines Phasendetektors und die von einem Sollwertgeber gelieferten elektrischen Schwingungen an den anderen Eingang des Phasendetektors gelegt sind, bei der ferner der Ausgang des Phasendetektors zur Beaufschlagung eines Reglers verwendet ist, der seinerseits die Stellgröße für die Steuerung des einstellbaren Oszillators liefert, und bei der schließlich der Ausgangsteil des Reglers durch einen Tiefpaß gegeben ist. Diese Schaltung ist dadurch gekennzeichnet, daß der Eingang des Regelkreises durch einen kontinuierlich als auch stufenweise einstellbaren und zusammen mit dem Tiefpaß die Funktion eines Integrators liefernden Schaltungsteil, der insbesondere als einstellbare Ladungspumpe ausgebildet ist, gegeben ist. Man erreicht auf diese Weise eine besonders einfache digitale Steuerung des Regelvorgangs und damit der von dem spannungsgesteuerten Nachlaufoszillator VCO gelieferten Frequen $f_o$.

Hinsichtlich der Wirkung der erfindungsgemäßen Schaltung ist noch folgendes festzustellen: Beim Empfang einer bestimmten Eingangsfrequenz $f_i$ muß der Tuneroszillator VCO auf die Frequenz $f_o = f_i + f_{ZF}$ abgestimmt werden, was ersichtlich mit Hilfe des Frequenzsyntheseverfahrens erreicht wird. Der Empfangsfrequenz $f_i$ und damit der zugehörigen Oszillatorfrequenz $f_o$ ist nun gemäß der Beziehung

$$N = f_o / \Delta f_o$$

eine bestimmte Zahl N zugeordnet. Das Oszillatorraster $\Delta f_o$ ergibt sich gemäß

$$\Delta f_o = f_Q \cdot P/Q,$$

wobei P das im Vorteiler T1 und Q das in dem Teiler T3 eingestellte Teilerverhältnis bedeutet. Ist nun das System eingerastet, was z.B. durch eine mit dem Phasendetektor PD verbundene Lock-Indications-Anlage angezeigt wird, und stellt sich das Eingangssignal $f_i$ als mit ausreichender Qualität versehen heraus (was z.B. über Anzeichen wie die Regelspannung, die Rauschsperre bzw. die TV-Identification festgestellt wird), so wird vom Abstimmprozessor ST auf den ZF-PLL-Regelzustand der erfindungsgemäßen Anlage durch entsprechende Betätigung des Schalters S umgeschaltet. Beispielsweise geschieht dies durch Eingabe der Zahl $N_{FZ} = f_{FZ}\, q/f_Q$ (wobei $f_Q$ die vom Referenzoszillator aufgrund der Steuerung durch die Steuerung durch den Schwingquarz Q erhaltene Ausgangsfrequenz des Sollwertgeberoszillators SG und $f_Q$ das im Teiler T3 eingestellte Teilerverhältnis bedeutet) in den durch das Latch L und das Schieberegister SR gegebenen Schaltungsteil.

Die Zwischenfrequenz $f_{ZF}$ kann im Raster $f_{ZF} = f_Q/q = f_o/P$ variiert werden. Etwaige Temperaturdriften im Tuner VCO bzw. im ZF-Verstärker V werden dabei eliminiert. Die Stabilität der Frequenzen wird also ausschließlich von dem durch den Quarz Q gesteuerten Oszillator SG bestimmt.

1 Figur
4 Patentansprüche

0075332

VPA 81 P 1 1 4 5 E

Patentansprüche

1.) Empfängerschaltung mit einer durch das informationsbehaftete Eingangssignal sowie durch einen mittels eines nach dem Frequenzsyntheseverfahren arbeitenden Regelkreises geregelten Oszillator beaufschlagten Mischstufe, an deren Ausgang ein mit der empfangenen Information versehenes und an einen der weiteren Auswertung dienenden Schaltungsteil weiterzugebendes Zwischenfrequenzsignal erscheint, dadurch gekennzeichnet, daß alternativ zu der vom Oszillator (VCO) gelieferten Frequenz oder einer von dieser Frequenz durch Frequenzteilung abgeleiteten Istwertfrequenz ($f_o$) die vom Ausgang der Mischstufe (Mi) gelieferte Zwischenfrequenz ($f_{ZF}$) oder eine von dieser durch Frequenzteilung erhaltene Frequenz als Istwert an den nach dem Frequenzsyntheseverfahren arbeitenden Regelkreis unter Beibehaltung des Oszillators (VCO) als Stellglied anschaltbar ist.

2.) Schaltung nach Anspruch 1, dadurch gekennzeichnet, daß der Sollwertgeber (SG) für den Regelkreis ein quarzgesteuerter Oszillator ist, dessen Ausgangssignal - ggf. unter Zwischenschaltung eines Frequenzteilers (T3) - an den Eingang eines die Regelabweichung feststellenden Phasendetektors (PD) gelegt ist, während der Istwert-Eingang des Phasendetektors (PD) - ggf. unter Vermittlung eines weiteren Frequenzteilers (T1) - gesteuert durch einen Wechselschalter (S) alternativ durch das Ausgangssignal ($f_o$) des Oszillators (VCO) oder durch das - ggf. unter Vermittlung eines dritten Frequenzteilers (T2) zugeführte Zwischenfrequenzsignal ($f_{ZF}$) beaufschlagt ist.

3.) Schaltung nach Anspruch 1 oder 2, dadurch gekennzeichnet, daß die Einstellung des nach dem Frequenzsyntheseverfahren arbeitenden Regelkreises über einen Mikroprozessor erfolgt.

0075332

VEAP 1145 E

4.) Schaltung nach einem der Ansprüche 1 bis 3, dadurch gekennzeichnet, daß der nach dem Frequenzsyntheseverfahren arbeitende Regelkreis (PD, RG, SG, VCO) entsprechend der Patentanmeldung P 31 20 930.0 ausgestaltet ist.

RU

V

ZFi

Mi

fi

VCO

T1

T2

S

N, N_ZF

SR + L

ST

PD

RG

T3

SG

Q